Europäisches Patentamt

(19) European Patent Office

Office européen des brevets

(11) EP 0 862 060 A2

(12) **EUROPEAN PATENT APPLICATION**

(43) Date of publication:
02.09.1998 Bulletin 1998/36

(51) Int. Cl.⁶: **G01R 19/02**

(21) Application number: 97306146.8

(22) Date of filing: 13.08.1997

(84) Designated Contracting States:
AT BE CH DE DK ES FI FR GB GR IE IT LI LU MC
NL PT SE

(30) Priority: 18.02.1997 US 802020

(71) Applicant: FLUKE CORPORATION
Everett, Washington 98206-9090 (US)

(72) Inventors:
• Swift, Steven D.
Seattle, WA 98155 (US)

• Huber, Clark N.
Everett, WA 98203-1664 (US)
• Kirita, Michael E.
Bothell, WA 98012 (US)

(74) Representative:
Burke, Steven David et al
R.G.C. Jenkins & Co.
26 Caxton Street
London SW1H 0RJ (GB)

(54) **RMS converter using digital filtering**

(57) In accordance with the present invention, an rms (root mean square) converter using digital samples is provided. The rms converter is implemented using a squaring circuit followed by an rms digital filter and a square root circuit. Each digital sample from the ADC is squared and then presented to an rms digital filter which produces filtered digital samples. A square root circuit then calculates the rms values from the filtered digital samples. The rms digital filter has a transfer function that is essentially a low pass filter that extracts the rms value from the stream of digital samples in a continuous manner without regard to the period or waveshape of the signal.

FIG. 6

EP 0 862 060 A2

## Description

### Background of the Invention

This invention relates generally to root mean square (rms) converter circuits and in particular to an rms converter for determining the rms value of a signal with no knowledge of the signal period.

The ability to determine the rms value of signals having arbitrary waveshapes with high accuracy and reliability is of great importance in test and measurement equipment. Most multimeters and voltmeters used for measuring alternating current (a.c.) line voltage provide a facility to do so in terms of volts rms as the most meaningful measurement rather than volts peak-peak. Early multimeters used a diode rectifiers and averaging circuits to provide measurements in terms of volts rms. Such an arrangement provided accurate readings only when the signal has a sinusoidal waveshape but will produce measurement errors often in excess of 10% for other types of waveshapes such as square waves.

RMS to d.c. converters improve on the limitations of the diode averaging by producing a "true-rms" value in the form of a d.c. voltage for signals having a much wider variety of waveshapes. Thermal rms converters are a variety of rms converters that operate by applying a signal having an arbitrary waveshape to a resistor in a thermally isolated environment. The power dissipated in the resistor is proportional to the square of the voltage of the signal which produces a temperature rise. The temperature rise and the equivalent heating power of the signal in the resistor is duplicated in a second, matched resistor by adjusting a d.c. voltage. The d.c. voltage thus produced corresponds to the rms value of the signal with no regard to the period or waveshape of the signal.

A thermal rms converter using thermally isolated, matched resistors is discussed in U.S. Patent 4,346,291, "Thermally Isolated Monolithic Semiconductor Die", issued August 24, 1982, to Chapel, Jr. et al., Fluke Corporation, assignee. A circuit for increasing the accuracy of thermal rms converters is discussed in U.S. Patent 4,274,143, "Recirculating RMS AC Conversion Method and Apparatus", issued June 16, 1981, to Brodie, et al., Fluke Corporation, assignee. Thermal rms converters, while allowing for relatively high accuracy rms to d.c. conversions if carefully implemented, are relatively expensive and complex to manufacture, are easily destroyed, and have relatively slow response times.

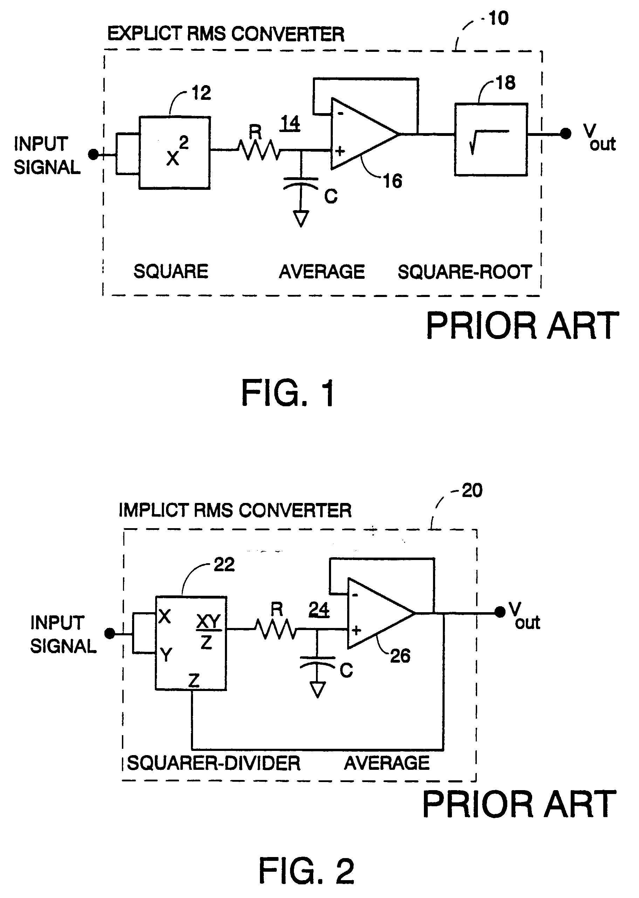

Another variety of rms to d.c. converter is the monolithic rms converter which employs analog circuits such as amplifiers, multipliers, dividers, and integrators within a single integrated circuit. Monolithic rms converters are commercially available, relatively inexpensive to produce, and can handle a wider variety of waveshapes than the diode averaging techniques. Several types of monolithic rms converters exist in the prior art including explicit rms converters as shown in FIG. 1 and implicit rms converters as shown in FIG 2.

As shown in FIG. 1, an explicit rms converter 10 accepts the input signal, squares it in a squaring circuit, averages the squared value over a predetermined averaging period in an averaging circuit 14 comprising a resistor R, a capacitor C, and a buffer 16, , and then takes the square root in a square root circuit 18 to obtain a d.c. signal Vout that is representative of the rms level of the input signal. The capacitor C and resistor R together comprise a one-pole filter circuit and have values selected according to the predetermined averaging period. The capacitor C is usually the only external component that must be added to the explicit rms converter. The value of the averaging capacitor also determines the low frequency accuracy, ripple level, and settling time of the monolithic rms converter, all of which must be traded off for each particular application. Because the squaring circuit may develop voltages that vary enormously in response to the input signal, the dynamic range of the explicit rms converter 10 is relatively limited.

In FIG. 2, there is shown an implicit rms converter 20 in which the input signal is accepted by a squarer-divider circuit 22 which performs the square root function implicitly without having to actually produce the square of the amplitude of the input signal, thereby increasing the effective dynamic range so that a greater range of input signal amplitudes may be accommodated. The output of the squarer-divider is provided to an averaging circuit 24 which is comprised of the one-pole filter using the resistor R and the capacitor C and a buffer 26 to develop the output signal Vout. Most monolithic rms converters operate using some form of the implicit rms converter method in order to get around the dynamic range limitation of the explicit rms converter topology.

In either the explicit or implicit rms converter topologies, in order to obtain rms to d.c. conversions within a specified degree of accuracy in a monolithic rms converter, the input signal being measured is subject to several restraints. First, the input signal must be periodic. Second, the predetermined averaging period set by the value of the averaging capacitor must be long enough to allow averaging multiple signal periods in order to reduce the ripple component in the output signal. As noted above, the filtering circuit is typically a one-pole filter. Finally, the input signal must have less than a certain crest factor which is defined as the peak value of an input signal divided by its rms value. Thus, the input signal being measured cannot be truly arbitrary and erroneous measurement results may be obtained if the input signal deviates from any of these constraints.

Because of gain-bandwidth limitations of their analog circuits, monolithic rms converters also suffer from bandwidth variations as a function of input signal amplitude. To obtain the flattest bandwidth, which is the output signal level in response to a constant input voltage over a frequency range of interest, the input signal should be adjusted so that the maximum rms signal level corresponds to the full scale input level of the monolithic rms converter.

Analog-to-digital converters (ADCs), which had formerly been placed behind the monolithic rms converter to convert the d.c. voltage into digital samples, are now commonly replacing the monolithic rms converter in newer instrument designs to measure input signals at the front end. ADCs now provide higher sampling rates and measurement accuracy that allow for sampling the signal directly and storing the digital measurement values as a time record. Using mathematical operations that integrate the signal voltage over a predetermined number of digital measurement values from the time record, the rms value of the signal can be calculated. However, this mathematical method requires that the input signal be periodic and that the signal period be known. If the signal period is unknown or the signal is aperiodic, a default period must be chosen for the calculation which may lead to erroneous results.

Therefore, it would be desirable to provide a method and apparatus for measuring rms values from digital samples with no requirement that the period of the signal being measured be known or even that the signal be periodic.

## Summary of the Invention

In accordance with the present invention, an rms converter using digital samples is provided. The rms converter is implemented using a squaring circuit followed by an rms digital filter and a square root circuit. Each digital sample from the ADC is squared and then presented to a digital filter where it is filtered in a continuous fashion to produce rms values.

The transfer function of the rms digital filter of the present invention is modeled after the thermodynamic principles of applying a signal to a temperature sensitive resistor in the manner of the thermal rms converter. In this way, the rms value may be obtained using a stream of digital samples from a signal without regard to the period of the signal while avoiding the difficulties of providing thermally isolated matched resistors or in having to choose an integration period to calculate the rms value.

According to the thermodynamic model, the resistor heats up according to the power in the signal applied across it such that the power dissipated in the resistor is proportional to the square of the signal voltage. The resistor heats to an equilibrium point where the energy added is equal to the energy lost. The rms value of the signal at this equilibrium point is the same as the amplitude of a d.c. signal that heats the resistor to the same temperature. As such, the resistor acts as filter for the energy applied to it and the signal period is not relevant to its operation. There is no requirement that the signal be periodic because this filtering action takes place continuously.

In modeling the thermodynamic behavior of the resistor, the rms digital filter may be implemented in its simplest form as an infinite impulse response (IIR) filter according to the following general equation

$$Y_n = aX_n{}^2 + bY_{n-1}$$

in which the filter constants a and b are chosen so that

$$a + b = 1$$

The rms digital filter is then implemented according to following equation:

$$Y_n = a(x_n)^2 - aY_{n-1} + Y_{n-1}$$

where:

$Y_n$ is the present filtered digital sample
$Y_{n-1}$ is the past filtered digital sample
$X_n$ is the present digital sample

In an equilibrium state, $Y_n = Y_{n-1}$ and added energy, represented by $a(x_n)^2$, equals energy lost, represented by $aY_{n-1}$, making $Y_n$ and $X_n$ steady values. Therefore, $X_n$ is equivalent to a steady d.c. value which is the square root of $Y_n$ and thus represents the rms value.

The rms digital filter within the rms converter of the present invention extends this fundamental concept by having a transfer function that is essentially a low pass filter that extracts the rms value from the stream of digital samples in a continuous manner thus requiring no knowledge of the period of the signal. The squaring and rms digital filtering operations take place in real-time using each digital measurement value as it arrives. Next, a square root of the digital measurement values is taken, preferably only when a display update is made, to obtain the present rms value from the rms filter. In addition, the rms digital filter is optimized in terms of settling time, stop band frequency and attenuation, pass band ripple, and other filter parameters using optimization techniques known in the art. For a given accuracy and resolution, the rms digital filter can be optimized to provide faster responses than prior art rms converters.

In a measurement instrument for measuring rms values employing the rms converter according to the present invention, an input signal is connected to a front end circuit which scales the signal amplitude to allow for proper sampling by a sampling system. A measurement bandwidth, which is typically determined as a design requirement for the measurement instrument, determines the minimum sample rate needed for the sampling system. Frequency components in the input signal beyond the measurement bandwidth would not be measured. The sampling system may comprise a sigma-delta converter followed by a decimation filter or alternatively a conventional ADC. The sampling system samples the input signal having an arbitrary waveshape to provide the digital samples at a sample rate to the rms converter. The rms values developed as described above from the rms converter are provided to a display on the measurement instrument, typically at an update rate determined by a microprocessor.

One object of the present invention is to provide an rms to d.c. converter that operates independently of the signal period.

Another object of the present invention is to provide an rms converter comprising a squaring circuit, a digital filter, and a square root circuit that operate on digital samples independently of the signal period.

An additional object of the present invention is to provide an rms converter having constant bandwidth over a wide range of input signal amplitudes.

A further object of the present invention is to provide a method for providing rms values using a digital filter to extract the rms values from a stream of digital samples.

Other features, attainments, and advantages will become apparent to those skilled in the art upon a reading of the following description when taken in conjunction with the accompanying drawings.

## Brief Description of the Drawings

FIG. 1 is a drawing of an explicit rms converter according to the prior art;

FIG. 2 is a drawing of an implicit rms converter according to the prior art;

FIG. 3 is a drawing of a measurement instrument as applied in measuring the rms value of an a.c. signal of unknown period and waveshape;

FIG. 4 is a simplified block diagram of the measurement instrument of FIG. 3 according to the preferred embodiment of the present invention;

FIG. 5 is a simplified block diagram of the measurement instrument of FIG. 3 according to an alternative embodiment of the present invention; and

FIG. 6 is a simplified block diagram of the rms converter according to the present invention.

## Detailed Description of the Invention

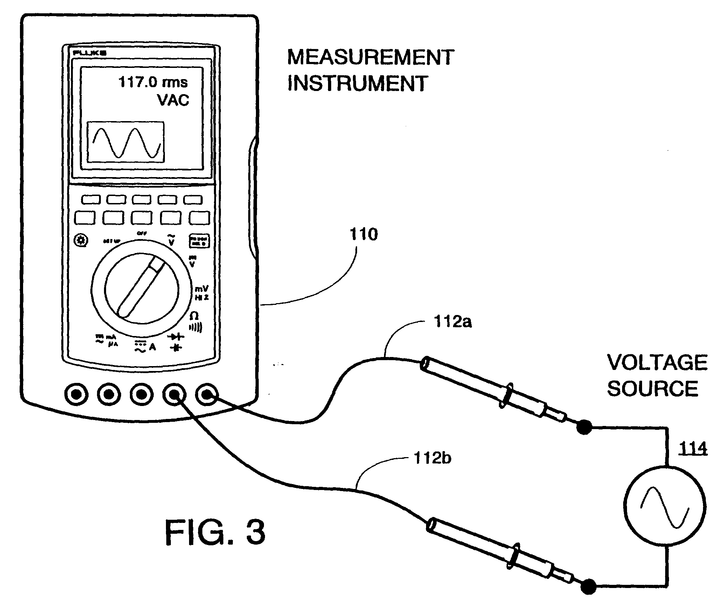

FIG. 3 is a drawing (not to scale) of a measurement instrument 110 coupled via test leads 112a and 112b to a voltage source 114 to obtain an input signal. The measurement instrument 110 is designed to be applied in service, installation, and maintenance environments in which a variety of input signals having a variety of waveshapes may be encountered. The measurement instrument 110 may be implemented in the form of a digital multimeter, an oscilloscope, or other measurement instrument for measuring input signal voltages.

The input signal provided by the voltage source 114 may be an alternating current (a.c.) signal, a direct current (d.c.) signal or a combination of a.c. plus d.c. on the same waveform. The input signal may have a sinusoidal waveshape with a stable period or it may simply be random noise with no period or discernible waveshape. It is desirable that the measurement instrument 110 be capable of displaying the rms (root-mean-square) value of the input signal without any knowledge of its period or waveshape within a desired measurement bandwidth.

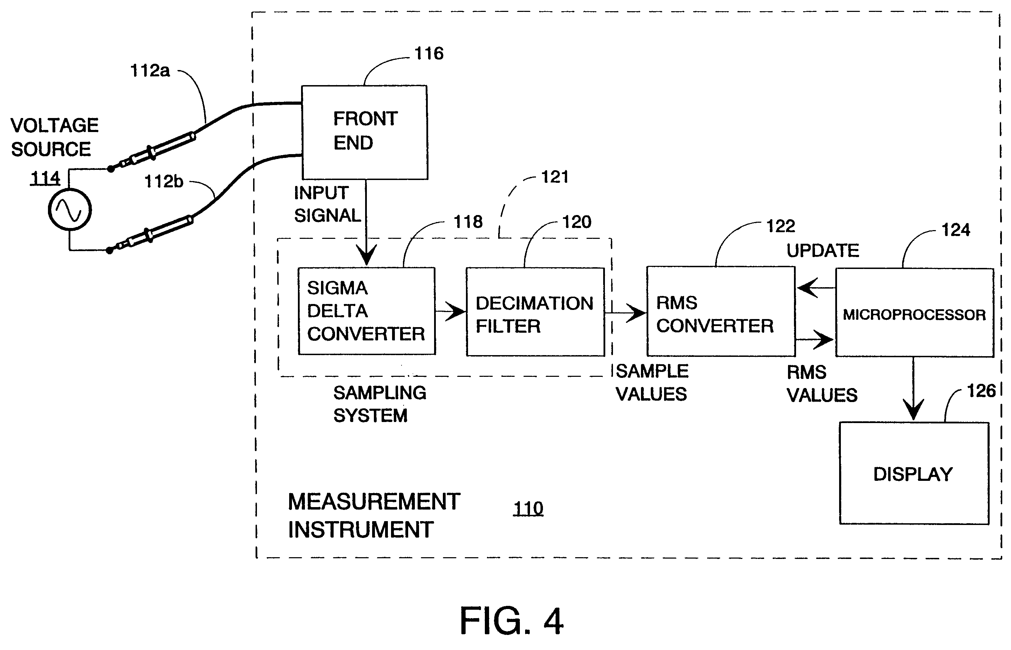

FIG. 4 is a simplified block diagram of the measurement instrument 110 (shown in FIG. 3) according to the preferred embodiment of the present invention. The voltage source 14 is coupled via the test leads 112a and 112b to a front end 116 within the measurement instrument 110. The front end 116 may contain over-voltage and over-current protection circuits, amplifiers, attenuators, and filters in order to provide a scaled input signal of suitable amplitude level and bandwidth for conversion into digital samples.

Sigma-delta converter 118 is an over-sampling type analog to digital converter (ADC) which generates raw sample data at a sample rate substantially higher than the Nyquist rate for a selected measurement bandwidth, as is known in the art. The raw sample data may be converted to digital samples at base band using a decimation filter 120 as is also known in the art. In the preferred embodiment, the measurement bandwidth was chosen to be 500 kilohertz, with the sigma-delta converter 118 operating at a sample rate of ten megasamples per second (10 MS/s) for a 20:1 ratio. The sigma-delta converter 118 generates the raw sample data with a resolution of 5 bits which is supplied to the decimation filter 120 which low-pass filters the raw sample data to provide digital samples at 2.5 MS/s with a resolution of 14 bits.

The decimation filter 120 may be implemented as a finite impulse response (FIR) filter, as a infinite impulse response (IIR) filter, or as a hybrid of FIR and IIR filters, with the filter constants and structure chosen to obtain a desired transfer function. The sigma-delta converter topology is desirable because no precision components are needed in the converter, thus allowing for the circuitry to be implemented easily as a monolithic integrated circuit as is known in the art. The sigma-delta converter 118 and decimation filter 120 collectively comprise a sampling system 121 which converts the input signal to a stream of digital samples according to a sample rate.

The digital samples are provided as a continuous data stream at a rate of 2.5 MS/s to an rms converter 122. The rms converter 122 processes each of the digital samples in the continuous data stream as they arrive with no knowledge of the periodicity or waveshape of the input signal, as explained in more detail below. A microprocessor 124 receives rms values produced by the rms filter and selectively provides the rms values to a display 126 where they may be displayed in numerical or graphical format as desired. The rms values may be provided continuously or in response to an update signal from the microprocessor 124.

The rms converter 122 offers a number of advantages over the prior art particularly when applied in the measurement instrument 110 as a handheld, battery-operated package. The sigma-delta converter 118, the decimation filter 120 and the rms converter 122 may all be implemented as monolithic integrated circuits, with a minimum of external precision components, thus reducing cost, board space, power consumption, and manufacturing complexity.

The rms converter 122 further offers substantial performance advantages over the prior art. The crest factor, a substantial limitation in monolithic rms converters, is limited in the present invention only by the sampling system 21 and word length of the rms digital filter 132. At the same time, the a.c. bandwidth of the rms converter 122 is constant, being defined according the filter constants applied in the rms digital filter 132. Furthermore, the performance of the rms converter 122, defined in terms of transfer function and a.c. bandwidth, are substantially constant over a wide range of amplitudes of the input signal. The rms digital filter 132 may have as many poles as needed to achieve adequate stopband rejection of a.c. ripple components while maintaining a desired settling time and no overshoot in its pulse response characteristic.

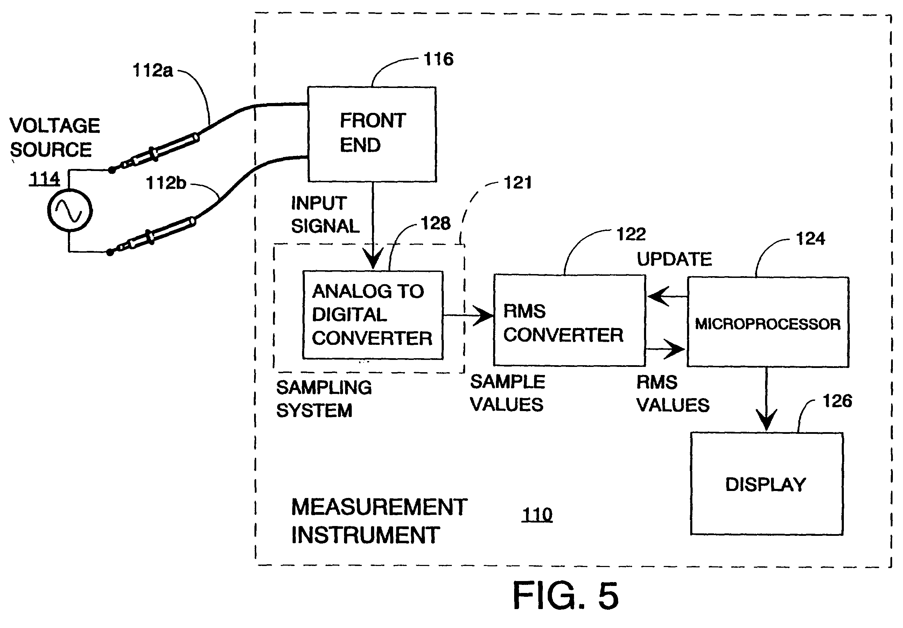

FIG. 5 is a simplified block diagram of the measurement instrument 110 (shown in FIG. 3) according to an alternative embodiment of the present invention in which the sampling system 121 consists of an analog-to-digital converter (ADC) 128. The voltage source 114 is coupled via the test leads 112a and 112b to a front end 116 within the measurement instrument 110. The front end 116 may contain over-voltage and over-current protection circuits, amplifiers, attenuators, and filters in order to provide the input signal of suitable amplitude level and bandwidth to the sampling system 121.

The ADC 118 generates digital samples at a sample rate higher than the Nyquist rate which is twice the measurement bandwidth, as is known in the art. Because the measurement bandwidth was chosen to be 500 kilohertz, the ADC 128 must operate at a sample rate exceeding 1 MS/s and preferrably at 10 MS/s, with the actual sample rate driven by considerations of conversion accuracy. Other ADC technologies may be readily substituted for the ADC 118, with consideration given to component cost, maximum sample rate, power consumption, as well as converter accuracy and resolution, to provide digital samples representative of the input signal to the rms converter 122.

The digital samples are provided as a continuous data stream from the ADC 128 to the rms converter 122. The rms converter 122 processes each of the digital samples in the continuous data stream as they arrive with no knowledge of the periodicity or waveshape of the input signal, as explained in more detail below. A microprocessor 124 receives the rms values produced by the rms converter and selectively provides the rms values to a display 126 where they may be displayed in numerical or graphical format as desired. The rms values may be provided continuously or in response to an update signal from the microprocessor 124.

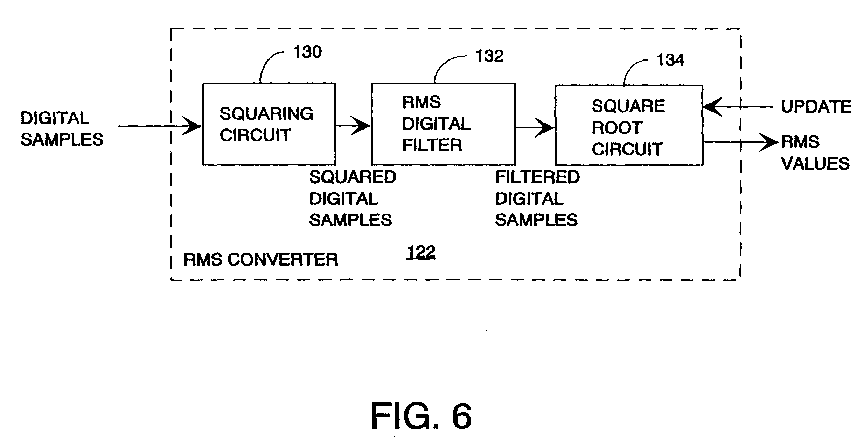

FIG. 6 is a simplified block diagram of the rms converter 122 according to the present invention. Digital samples from the sigma-delta converter 118 and decimation filter 120 as shown in FIG. 4 or the ADC 128 as shown in FIG. 5 arrive at the rms converter 122. Each digital sample is squared in the squaring circuit 130 to produce squared digital samples. Each squared digital sample is provided to an rms digital filter 132 which has filter coefficients chosen to allow the rms digital filter 132 to operate as a low pass filter. The filter coefficients and digital filter topology may be designed according to known IIR and FIR techniques, or a combination of FIR and IIR techniques, to provide a low pass filter having desired characteristics. In the preferred embodiment, the rms digital filter 32 has the following characteristics:

measurement bandwidth
500 kilohertz maximum
stopband of -123 decibels
49.9 hertz maximum
settling time to 0.001% of final value
0.5 seconds maximum
step response overshoot
0.0% maximum
output data rates
0.125, 0.5, 2, and 1000 hertz

In the digital rms filter 132, it was important that there be no overshoot in the step response along with a high stopband rejection of 50/60 hertz: ripple from power line frequencies. Filtered rms values produced by the digital rms filter 132 are provided to a square root circuit 134 which produces the rms value by taking the square root of the present filtered rms value, either continuously or as needed in response to the update signal received from the microprocessor 124.

It will be obvious to those having ordinary skill in the art that many changes may be made in the details of the above described preferred embodiments of the invention without departing from the spirit of the invention in its broader aspects. For example, the squaring circuit 130, the rms digital filter 132, and the square root circuit 134 may be implemented in hardware, in software, or a combination thereof according to the requirements of the application. The transfer function of the rms digital filter 132 is readily adaptable to a different sample rates and accuracy requirements. The sampling system 121 may comprise any of a variety of converter technologies suitable for generating digital samples of the input signal at a desired sample rate and accuracy. Therefore, the scope of the present invention should be determined by the following claims.

## Claims

1. An rms converter comprising:

   (a) a squaring circuit for receiving digital samples of an input signal of unknown period to produce squared digital samples;
   (b) an rms digital filter coupled to said squaring circuit to continuously receive said squared digital samples and produce filtered digital samples wherein said rms digital filter operates as a low pass filter; and
   (c) a square root circuit for calculating the square root of said filtered digital samples to produce an rms value of said input signal.

2. An rms converter according to claim 1 wherein said rms digital filter further comprises an IIR filter.

3. An rms converter according to claim 1 wherein said rms digital filter further comprises an FIR filter

4. An rms converter according to claim 1 wherein said input signal has an arbitrary waveshape.

5. An rms converter according to claim 1 wherein said square root circuit produces said rms value in response to an update signal.

6. A measurement instrument for measuring the rms value of an input signal of unknown period, comprising:

   (a) a sampling system coupled to said input signal to produce digital samples of said input signal;
   (b) an rms converter coupled to said sampling system to continuously receive said digital samples and calculate an rms value of said input signal;
   (c) a microprocessor for receiving said rms value from said rms converter and determining an update rate; and
   (d) a display coupled to said microprocessor for receiving and displaying said rms value at said update rate.

7. A measurement instrument for measuring the rms value of an input signal of unknown period according to claim 6, said rms converter further comprising:

   (a) a squaring circuit for receiving digital samples of said input signal to produce squared digital samples;
   (b) an rms digital filter coupled to said squaring circuit to receive said squared digital samples and produce filtered digital samples wherein said rms digital filter operates as a low pass filter; and
   (c) a square root circuit for calculating the square root of said filtered digital samples to produce said rms value of said input signal.

8. A measurement instrument for measuring the rms value of an input signal of unknown period according to claim 7, said rms digital filter further comprising an IIR filter.

9. A measurement instrument for measuring the rms value of an input signal of unknown period according to claim 7, said rms digital filter further comprising an FIR filter.

10. A measurement instrument for measuring the rms value of an input signal of unknown period according to claim 6 further comprising a front end circuit interposed between said input signal and said sampling system to scale said input signal for said sampling system.

11. A measurement instrument for measuring the rms value of an input signal of unknown period according to claim 6, said sampling system further comprising:

    (a) a sigma-delta converter coupled to said input signal to produce raw digital samples; and
    (b) a decimation filter coupled to said sigma-delta converter to receive said raw digital samples and produce said digital samples.

12. A measurement instrument for measuring the rms value of an input signal of unknown period according to claim 6, said sampling system further comprising an analog to digital converter.

13. A method of calculating rms values of an input signal of an unknown period, comprising:

    (a) producing digital samples from said input signal using a sampling system;

    (b) squaring each of said digital samples in a squaring circuit to produce squared digital samples;

    (c) filtering each of said squared digital samples in an rms digital filter in a continuous manner wherein said rms digital filter operates as a low pass filter to produce filtered digital samples; and

    (d) taking a square root of said filtered digital samples to produce said rms values of said input signal.

14. A method of determining the rms value of an input signal, comprising deriving successive digital samples of the input signal, squaring each sample and deriving said rms value from the squared samples using a low pass filter.

EXPLICT RMS CONVERTER

INPUT
SIGNAL

$X^2$

R    14

$-$
$+$    16

18

$V_{out}$

C

SQUARE          AVERAGE          SQUARE-ROOT

PRIOR ART

FIG. 1

IMPLICT RMS CONVERTER

INPUT
SIGNAL

X
$\frac{XY}{Z}$
Y

Z

R    24

$-$
$+$    26

$V_{out}$

C

SQUARER-DIVIDER          AVERAGE

PRIOR ART

FIG. 2

MEASUREMENT
INSTRUMENT

117.0 rms
VAC

110

112a

112b

VOLTAGE
SOURCE

114

FIG. 3

FIG. 4

EP 0 862 060 A2

FIG. 5

EP 0 862 060 A2

FIG. 6